# EUROPEAN PATENT APPLICATION

(11) **EP 4 571 831 A1**
(43) Date of publication of application: **18.06.2025**
(21) Application number: 24217242.7
(22) Date of filing: 03.12.2024
(51) Int. Cl.: H01L 23/492, H01L 23/34, H01L 23/50, H01L 23/528, H01L 23/538, H01L 25/07

(54) **POWER MODULE**

(30) Priority: 15.12.2023 CN 202323442856 U
(71) Applicant: ZF Friedrichshafen AG, 88046 Friedrichshafen (DE)
(72) Inventor: Yuan, George, Shanghai, 201615 (CN); Xu, Qing, Shanghai, 201615 (CN)
(74) Representative: ZF Friedrichshafen AG

(57) **Abstract**

The disclosure provides a power module, including semiconductor chips and a busbar, where each of the semiconductor chips includes a first semiconductor chip and a second semiconductor chip, and the busbar includes a DC- busbar, an AC busbar and a DC+ busbar arranged in sequence. The AC busbar has a plurality of first cavities therein, each of the first cavities having one of the first semiconductor chip arranged therein, and the DC+ busbar has a plurality of second cavities therein, each of the second cavities having one of the second semiconductor chips arranged therein. Each of the first semiconductor chips has a source electrically connected to the DC- busbar and a drain electrically connected to the AC busbar, each of the second semiconductor chips has a source electrically connected to the AC busbar and a drain electrically connected to the DC+ busbar, and the DC- busbar, the AC busbar and the DC+ busbar are all embedded into a PCB. The power module according to the disclosure is smaller in size, more compact in structure and higher in integration level.

## Description

### TECHNICAL FIELD

The disclosure generally relates to the technical field of semiconductor devices, and in particular to a power module.

### BACKGROUND ART

Semiconductor devices are electronic devices that use the special electrical properties of semiconductor materials to achieve specific functions, and can be used for generating, controlling, receiving, transforming and amplifying signals and performing energy conversion. A power module (power supply module) is a power semiconductor device usually composed of a metal housing, a circuit board and elements. Various elements which may be diodes, transistors, capacitors, inductors or the like are arranged on the circuit board. In addition, depending on different specific applications, the power module may also include other components such as a control circuit and a protective circuit. The power modules of different types and uses may be somewhat different in structure.

The power module is typically used for high-voltage and high-current power control and conversion tasks such as a motor drive, an inverter, a power supply system, an electric vehicle driver and an industrial frequency converter, and has gradually moved into a development phase centered on silicon carbide MOSFETfrom the initial silicon-based IGBT era.

The smaller the size of the power module is, the more advantageous the power module is. For example, at the same power output, a smaller size means a higher power density. The overall size and weight of an device can be reduced to make the power module more portable and lightweight, and the size and the weight of a heat dissipation system can also be reduced to reduce energy loss during a heat dissipation process. In addition, the smaller the size is, the lower the heat capacity and the faster the heat conduction of the power module are, and the higher the response speed of the device is. It thus can be seen that the miniaturization of the power module is one of the goals of continuous optimization of the power module.

### SUMMARY

A technical problem to be solved by the disclosure is to provide a power module that is smaller in size, more compact in structure and higher in integration level.

In order to solve the above technical problem, the disclosure provides a power module, including: semiconductor chips and a busbar, where each of the semiconductor chip includes a first semiconductor chip and a second semiconductor chip, and the busbar comprises a DC-busbar, an AC busbar and a DC+ busbar arranged in sequence; the AC busbar has a plurality of first cavities therein, each of the first cavities having one of the first semiconductor chips arranged therein; the DC+ busbar has a plurality of second cavities therein, each of the second cavities having one of the second semiconductor chips arranged therein; each of the first semiconductor chips has a source electrically connected to the DC- busbar and a drain electrically connected to the AC busbar; each of the second semiconductor chips has a source electrically connected to the AC busbar and a drain electrically connected to the DC+ busbar; and the DC- busbar, the AC busbar and the DC+ busbar are all embedded into a PCB.

Optionally, the semiconductor chip is arranged the first cavity and/or the second cavity by means of welding or silver sintering.

Optionally, the source of the first semiconductor chip is electrically connected to the DC-busbar by means of a first U-shaped connector, and the source of the second semiconductor chip is electrically connected to the AC busbar by means of a second U-shaped connector.

Optionally, a surface of the first U-shaped connector and/or the second U-shaped connector is provided with a copper coating.

Optionally, an element connected to the first U-shaped connector and/or the second U-shaped connector has a connecting hole, and the first U-shaped connector and/or the second U-shaped connector is embedded into the connecting hole; where the element comprises the semiconductor chips and the busbar.

Optionally, at least two connecting holes are provided at a connection between the element and the first U-shaped connector and/or the second U-shaped connector, and the first U-shaped connector and/or the second U-shaped connector has at least two connecting branches at a connecting end.

Optionally, a resin layer is provided on a back surface of the power module, and a cooling structure is arranged on a surface of the resin layer.

Optionally, the busbar, at side edges, has undercut structures recessed toward a bottom of the busbar.

Optionally, the undercut structures are arranged separately on two sides of the busbar or arranged on two sides of the busbar as a whole piece without separation.

Optionally, an edge of a cross section of each of the undercut structures is configured as a right angle, a straight line, or an arc.

Compared with the prior art, the disclosure has the following advantages. In the improved power module, the AC busbar has a plurality of first cavities therein, each of the first cavities having one of the first semiconductor chips arranged therein, and the DC+ busbar has a plurality of second cavities therein, each of the second cavities having one of the second semiconductor chips arranged therein; and each of the first semiconductor chips has a source electrically connected to the DC- busbar and a drain electrically connected to the AC busbar, each of the second semiconductor chips has a source electrically connected to the AC busbar and a drain electrically connected to the DC+ busbar, and the DC- busbar, the AC busbar and the DC+ busbar are all embedded into a PCB, therefore, the semiconductor chips make full use of the space of the busbar, and the busbar may not take up space other than the PCB, which in turn resulting in that the power module is smaller in size, more compact in structure and higher in integration level.

### BRIEF DESCRIPTION OF THE DRAWINGS

The accompanying drawings are included to provide a further understanding of the present application and are incorporated into and form a part of the present application, show embodiments of the present application, and serve to, together with the description, explain the principles of the present application. In the accompanying drawings:
FIG. 1 is a schematic structural diagram of a power module according to an embodiment of the disclosure;
FIG. 2 is a schematic diagram of an enlarged structure of part A of FIG. 1;
FIG. 3 is a top view of a busbar and its associated structures according to an embodiment of the disclosure;
FIG. 4 is top view of another busbar and its associated structures according to an embodiment of the disclosure;
FIG. 5 is a schematic structural diagram of another power module according to an embodiment of the disclosure; and
FIG. 6 is a schematic structural diagram of yet another power module according to an embodiment of the disclosure.

Reference signs in the figures are represented as below:
100 - semiconductor chip, 110 - first semiconductor chip, 120 - second semiconductor chip;
101 - first gate, 102 - second gate;
200 - busbar, 210 - DC- busbar, 220 - AC busbar, 230 - DC+ busbar;
201 - first cavity, 202 - second cavity;
300 - printed circuit board (PCB);
301 - first U-shaped connector, 302 - second U-shaped connector, 303 connecting branch;
400 - resin layer;
500 - cooling structure, 501 - fin;
600 - undercut structure.

### DETAILED DESCRIPTION OF EMBODIMENTS

To describe technical solutions of embodiments of the present application more clearly, the accompanying drawings required for describing the embodiments will be briefly described below. Obviously, the accompanying drawings described below show merely some of the examples or embodiments of the present application, and those of ordinary skill in the art would also have applied the present application to other similar scenarios according to these accompanying drawings without involving any creative effort. Unless obvious from the language context or otherwise illustrated, the same reference numerals in the drawings represent the same structure or operation.

Furthermore, it should be noted that, the use of terms such as "first" and "second" to define parts is merely for ease of facilitating differentiation of the corresponding parts. If not otherwise stated, the above terms have no special meanings and thus cannot be construed as limiting the scope of protection of the present application. Furthermore, although the terms used in the present application are selected from well-known common terms, some of the terms mentioned in the description of the present application may have been selected by the applicant according to his or her determination, and the detailed meaning thereof is described in the relevant section described herein. Furthermore, the present application must be understood, not simply by the actual terms used but also by the meanings encompassed by each term.

It should be understood that when a component is said to be "located on another component", "connected to another component", "coupled to another component", or "in contact with another component", it may be directly located on the other component, connected or coupled to the other component, or in contact with the other component, or there may be an intervening component. In contrast, when a component is said to be "directly located on another component", "directly connected to another component", "directly coupled to another component", or "in direct contact with another component", there is no intervening component. Similarly, when a first component is said to be "in electrical contact with" or "electrically coupled to" a second component, there is an electrical path between the first component and the second component that allows the flow of current. The electrical path can include a capacitor, coupled inductors, and/or other components that allow the flow of current, even without direct contact between conductive components.

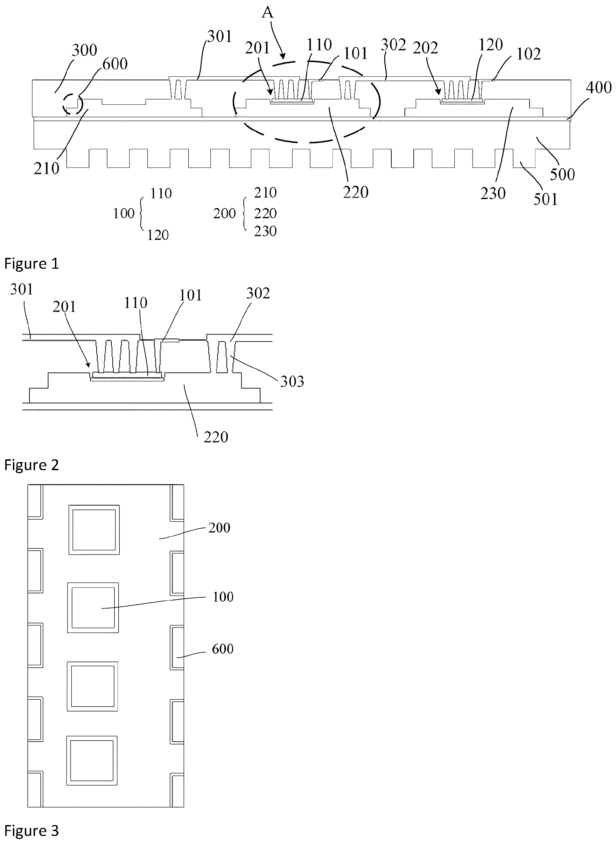

FIG. 1 is a schematic structural diagram of a power module according to an embodiment of the disclosure. Referring to FIG. 1, the main structure of the power module according to this embodiment includes:
semiconductor chips 100 and a busbar 200, where each of the semiconductor chips 100 includes a first semiconductor chip 110 and a second semiconductor chip 120, and the busbar 200 includes a DC- busbar 210, an AC busbar 220 and a DC+ busbar 230 that are arranged in sequence. The AC busbar 220 has a plurality of first cavities 201 therein, and each first cavity 201 has one first semiconductor chip 110 arranged therein. The DC+ busbar 230 has a plurality of second cavities 202, and each second cavity 202 has one second semiconductor chip 120 arranged therein. Each first semiconductor chip 110 has a source electrically connected to the DC- busbar 210 and a drain electrically connected to the AC busbar 220, and each second semiconductor chip 120 has a source electrically connected to the AC busbar 220 and a drain electrically connected to the DC+ busbar 230. The DC- busbar 210, the AC busbar 220 and the DC+ busbar 230 are all embedded into a PCB 300.

In this embodiment, the structure of the power module is mainly optimized in two aspects. First, the positions of the semiconductor chips 100 are improved. In order to reduce the space occupied by the semiconductor chips 100, in this embodiment, the AC busbar 220 has the plurality of first cavities 201 therein, each first cavity 201 has one first semiconductor chip 110 arranged therein, the DC+ busbar 230 has the plurality of second cavities 202 therein, and each second cavity 202 has one second semiconductor chip 120 arranged therein, such that the space of the busbar 200 can be fully utilized while the semiconductor chip 100 may not take up any other space, which reduces the size of the power module. In addition, in this embodiment, the DC- busbar 210, the AC busbar 220 and the DC+ busbar 230 are all embedded into the PCB 300, and the busbar 200 may not take up the space other than the PCB 300, which further reduces the size of the power module, such that the power module is of a more compact structure and has a higher integration level. Also, the semiconductor chips 100 are placed in the busbar 200, and each busbar 200 is embedded into the PCB 300, which shortens the circuit connection between various elements and can reduce stray inductance and improve the EMC performance of the power module.

In an example, the semiconductor chip 100 is arranged in the first cavity 201 and/or the second cavity 202 by means of welding or silver sintering.

Referring to FIG. 2, in an example of the first cavity 201 in the AC busbar 220, the first cavity 201 provides a position for arranging the first semiconductor chip 110, and there is a connection layer between the first semiconductor chip 110 and the AC busbar 220 in the figure. The connection layer is a welding layer when the first semiconductor chip 110 is arranged by means of welding, and the connection layer is a silver sintered layer when the first semiconductor chip 110 is arranged by means of silver sintering.

It can be known that the welding is to combine the semiconductor chips 100 with the busbar 200 by means of heating, pressurizing, or both, with or without a filler material. Silver sintering is a technique that uses micron or nano silver particles (silver paste, silver films and silver powder) to connect materials by means of sintering, which is a technique frequently used in power modules. Silver sintering has the characteristics of low-temperature connection, high-temperature service, high melting point and high reliability. Comparing the two connection methods of welding and silver sintering, welding is low in cost and materials used for welding are cheaper than materials for silver sintering, while silver sintering has high strength and stability and thus can meet the requirements of high-load and high-power applications. The materials for silver sintering also have high electrical conductivity and thermal conductivity, and thus can better meet the requirements for electrical conductivity and heat dissipation of the power module. In addition to the two preferred methods described above, there may also be other connection methods for the semiconductor chips 100, which will not be listed herein.

In an example, the first semiconductor chip 110 has a source electrically connected to the DC-busbar 210 by means of a first U-shaped connector 301, and the second semiconductor chip 120 has a source electrically connected to the AC busbar 220 by means of a second U-shaped connector 302.

Referring to FIG. 1, the DC- busbar 210, the AC busbar 220 and the DC+ busbar 230 are sequentially shown from left to right. In terms of position, the first U-shaped connector 301 is positioned between the DC- busbar 210 and the AC busbar 220, and the second U-shaped connector 302 is positioned between the AC busbar 220 and the DC+ busbar. Each busbar has a cavity therein, and the first semiconductor chip 110 and the second semiconductor chip 120 are arranged in the cavities of the AC busbar 220 and the DC+ busbar 230 respectively. In terms of connection relationship, the DC- busbar 210 is connected to the source of the first semiconductor chip 110 by means of the first U-shaped connector 301, the drain of the first semiconductor chip 110 is connected to the source of the second semiconductor chip 120 by means of the second U-shaped connector 302, and the drain of the second semiconductor chip 120 is connected to the DC+ busbar 230.

Of course, the power module according to this embodiment should further include a gate (a first gate 101) of the first semiconductor chip 110 and a gate (a second gate 102) of the second semiconductor chip 120, and the gates are connected to an external driving circuit, which will not be repeated herein.

In an example, a surface of the first U-shaped connector 301 and/or the second U-shaped connector 302 is provided with a copper coating. In one aspect, the copper coating has excellent electrical conductivity, which can improve the electrical conduction efficiency of the first U-shaped connector 301 and/or the second U-shaped connector 302, thereby improving the electrical properties of the power module. In another aspect, the copper coating can enhance the durability of the power module, such that the power module can be kept stable under complex environmental conditions and adapt to high-intensity operating environments.

In an example, an element connected to the first U-shaped connector 301 and/or the second U-shaped connector 302 has a connecting hole (not shown in the figure), and the first U-shaped connector 301 and/or the second U-shaped connector 302 is embedded into the connecting hole. The element includes the semiconductor chips 100 and the busbar 200.

The first U-shaped connector 301 and/or the second U-shaped connector 302 being connected to the element using the connecting hole provides the following advantages: first, the range of application is wide, that is, various elements can be electrically connected reliably through the connecting hole; and second, the maintenance is easy, that is, repair and replacement can be conducted once a problem is found at a connecting portion, so as to reduce the maintenance cost. By way of example, in this embodiment, the electrical connecting holes of both the semiconductor chips 100 and the busbar 200 may be formed by means of laser boring.

In an example, at least two connecting holes are provided at a connection between the element and the first U-shaped connector 301 and/or the second U-shaped connector 302, and the first U-shaped connector 301 and/or the second U-shaped connector 302 has at least two connecting branches 303 at a connecting end.

By way of example, as shown in FIG. 2, there are three connecting holes at the connection between the first U-shaped connector 301 and the first semiconductor chip, the first U-shaped connector 301 has three connecting branches 303 at this end, and each connecting hole is correspondingly connected to one connecting branch 303. In high-current applications, the plurality of connecting branches 303 share a high current, which prevents the electrical connection between the busbar 200 and the semiconductor chips 100 from overheat caused by the high current and ensures the stability of the electrical connection. Likewise, there are two connecting holes at the connection between the second U-shaped connector 302 and the AC busbar 220, the second U-shaped connector 302 has two connecting branches 303 at this end, and each connecting hole is correspondingly connected to one connecting branch 303.

In an example, a resin layer 400 is provided on a back surface of the power module, and a cooling structure 500 is arranged on a surface of the resin layer 400.

Still referring to FIG. 1, resin (the resin layer 400) with high thermal conductivity is connected to the back surface of the power module, and the resin layer 400 plays a very important role in terms of heat dissipation and insulation. A resin material used for the resin layer 400 has excellent thermal conductivity, which enhances the heat dissipation performance of the power module and improves the reliability and the service life of electronic elements. The resin layer 400 serves as an insulating layer to separate metal parts from a circuit board and prevent short circuiting of a current. The resin layer 400 may also protect the electronic elements inside the power module from external environments, such as temperature and humidity.

Further, the cooling structure 500 may be a cooling structure with fins (or pin fins) 501. The fins 501 can increase the area of heat dissipation, enhance the heat dissipation effect and improve the cooling efficiency.

In an example, the busbar 200, at side edges, has undercut structures 600 recessed toward the bottom of the busbar 200.

In this embodiment, the busbar 200 includes the DC- busbar 210, the AC busbar 220 and the DC+ busbar 230, and the busbar 200 may be reliably embedded into the PCB 300 by means of the undercut structures 600 at the side edges of the busbar 200.

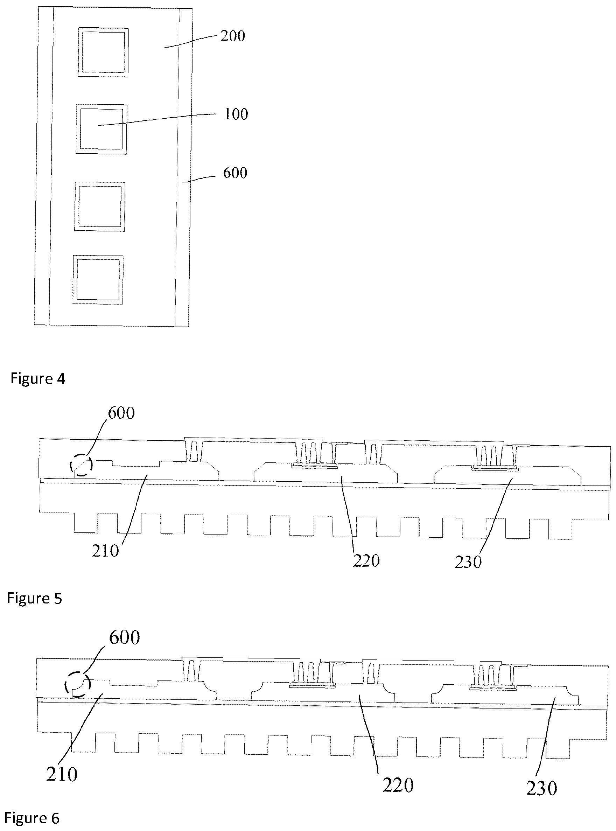

In an example, the undercut structures 600 are arranged separately on two sides of the busbar 200 or arranged on two sides of the busbar 200 as a whole piece without separation, as respectively shown in FIG. 3 and FIG. 4. The separated arrangement has the advantage that the busbar 200 may be better embedded, while the whole-piece arrangement has the advantage that the manufacturing process of the busbar 200 is simpler.

In an example, an edge of a cross section of the undercut structure 600 is configured as a right angle (L-shaped), a straight line, or an arc, as respectively shown in FIG. 1, FIG. 5 and FIG. 6. In this embodiment, a suitable configuration of the edge of the cross section may be selected according to the requirements of the manufacturing process and actual use conditions, which will not be repeated herein.

The power module according to this embodiment includes semiconductor chips 100 and a busbar 200, where each of the semiconductor chips 100 includes a first semiconductor chip 110 and a second semiconductor chip 120, and the busbar 200 includes a DC- busbar 210, an AC busbar 220 and a DC+ busbar 230 arranged in sequence. The AC busbar 220 has a plurality of first cavities 201 therein, each first cavity 201 having one first semiconductor chip 110 arranged therein, and the DC+ busbar 230 has a plurality of second cavities 202, each second cavity 202 having one second semiconductor chip 120 arranged therein. Each first semiconductor chip 110 has a source electrically connected to the DC- busbar 210 and a drain electrically connected to the AC busbar 220, each second semiconductor chip 120 has a source electrically connected to the AC busbar 220 and a drain electrically connected to the DC+ busbar 230, and the DC- busbar 210, the AC busbar 220 and DC+ busbar 230 are all embedded into a PCB 300. Based on this structure, the semiconductor chips 100 make full use of the space of the busbar 200, and the busbar 200 may not take up the space other than the PCB 300. Therefore, the power module is smaller in size, more compact in structure and higher in integration level.

The basic concepts have been described above. Obviously, for those skilled in the art, the above disclosure of the disclosure is merely used as an example and does not constitute a limitation on the present application. Although not explicitly stated herein, various modifications, improvements and amendments may be made to the present application by those skilled in the art. Such modifications, improvements and amendments are suggested in the present application, and therefore, such modifications, improvements and amendments still fall within the spirit and scope of the exemplary embodiments of the present application.

Meanwhile, the present application uses specific terms to describe the embodiments of the present application. For example, "one embodiment", "an embodiment", and/or "some embodiments" mean a feature, structure, or characteristic associated with at least one embodiment of the present application. Therefore, it should be emphasized and noted that two or more references to "an embodiment" or "one embodiment" or "an alternative embodiment" in various places in this specification do not necessarily indicate the same embodiment. Furthermore, some features, structures, or characteristics of the one or more embodiments of the present application may be combined appropriately.

Similarly, it should be noted that to simplify the expressions in the disclosure of the present application to assist in the understanding of one or more embodiments of the disclosure, a plurality of features may sometimes be incorporated into an embodiment and accompanying drawing, or a description thereof in the foregoing description of the embodiments of the present application. However, such a method in the disclosure does not mean that the subject of the present application requires more features than those mentioned in the claims. In fact, the features of the embodiments are less than all the features of a single embodiment disclosed above.

While the present application has been described with reference to the specific embodiments at hand, those of ordinary skill in the art would realize that the above embodiments are merely used to illustrate the present application, and various equivalent changes or substitutions can also be made without departing from the spirit of the present application. Therefore, any change and variation made to the above embodiments within the substantial spirit and scope of the present application shall fall within the scope of the claims of present application.

## Claims

1. A power module, comprising:
semiconductor chips and a busbar, wherein each of the semiconductor chip comprises a first semiconductor chip and a second semiconductor chip, and the busbar comprises a DC- busbar,
an AC busbar and a DC+ busbar arranged in sequence;
the AC busbar has a plurality of first cavities therein, each of the first cavities having one of the first semiconductor chips arranged therein; the DC+ busbar has a plurality of second cavities therein, each of the second cavities having one of the second semiconductor chips arranged therein;
each of the first semiconductor chips has a source electrically connected to the DC- busbar and a drain electrically connected to the AC busbar; each of the second semiconductor chips has a source electrically connected to the AC busbar and a drain electrically connected to the DC+ busbar; and
the DC- busbar, the AC busbar and the DC+ busbar are all embedded into a PCB.

2. The power module of claim 1, wherein the semiconductor chip is arranged in the first cavity and/or the second cavity by means of welding or silver sintering.

3. The power module of claim 1, wherein the source of the first semiconductor chip is electrically connected to the DC- busbar by means of a first U-shaped connector, and the source of the second semiconductor chip is electrically connected to the AC busbar by means of a second U-shaped connector.

4. The power module of claim 3, wherein a surface of the first U-shaped connector and/or the second U-shaped connector is provided with a copper coating.

5. The power module of claim 4, wherein an element connected to the first U-shaped connector and/or the second U-shaped connector has a connecting hole, and the first U-shaped connector and/or the second U-shaped connector is embedded into the connecting hole; wherein the element comprises the semiconductor chips and the busbar.

6. The power module of claim 5, wherein at least two connecting holes are provided at a connection between the element and the first U-shaped connector and/or the second U-shaped connector, and the first U-shaped connector and/or the second U-shaped connector has at least two connecting branches at a connecting end.

7. The power module of claim 1, wherein a resin layer is provided on a back surface of the power module, and a cooling structure is arranged on a surface of the resin layer.

8. The power module of claim 1, wherein the busbar, at side edges, has undercut structures recessed toward a bottom of the busbar.

9. The power module of claim 8, wherein the undercut structures are arranged separately on two sides of the busbar or arranged on two sides of the busbar as a whole piece without separation.

10. The power module of claim 8, wherein an edge of a cross section of each of the undercut structures is configured as a right angle, a straight line, or an arc.
